# EUROPEAN PATENT SPECIFICATION

(11) **EP 4 485 550 B1**
(45) Date of publication and mention of the grant of the patent: **27.05.2026**
(21) Application number: 22955337.5
(22) Date of filing: 18.08.2022
(51) Int. Cl.: H10F 19/31, H10F 77/20

(54) **SOLAR CELL AND PREPARATION METHOD THEREFOR**
SOLARZELLE UND HERSTELLUNGSVERFAHREN DAFÜR
CELLULE SOLAIRE ET SON PROCÉDÉ DE PRÉPARATION

(43) Date of publication of application: 01.01.2025
(73) Proprietor: Contemporary Amperex Technology Co., Limited, Ningde, Fujian 352100 (CN)
(72) Inventor: GUO, Wenming, Ningde, Fujian 352100 (CN); CHEN, Changsong, Ningde, Fujian 352100 (CN); LIU, Zhaohui, Ningde, Fujian 352100 (CN); TU, Bao, Ningde, Fujian 352100 (CN); LIANG, Weifeng, Ningde, Fujian 352100 (CN); KONG, Xiangguang, Ningde, Fujian 352100 (CN); CHEN, Guodong, Ningde, Fujian 352100 (CN); GUO, Yongsheng, Ningde, Fujian 352100 (CN)
(74) Representative: Kraus & Lederer PartGmbB
(86) International application number: PCT/CN2022/113293
(87) International publication number: WO 2024/036557

(56) References cited:
- WO-A1-2022/130062
- CN-A- 104 103 703
- CN-A- 106 784 040
- CN-A- 108 074 996
- CN-A- 112 054 078
- CN-A- 113 284 957
- CN-A- 114 156 411
- CN-A- 114 156 411
- CN-U- 208 706 663
- US-A1- 2013 133 720
- US-A1- 2014 190 563
- US-A1- 2022 344 524
- US-B2- 6 420 643

## Description

### TECHNICAL FIELD

This application relates to the technical field of solar cells, and in particular, to a solar cell and a preparation method therefor.

### BACKGROUND

Since a perovskite solar cell was first reported in 2009, it has been favored by researchers for its ultra-low material cost and solution preparation process, and the energy conversion efficiency of the perovskite solar cell with a small area (less than 1 cm²) has been increased from initial 3.8% to 25.8%. As the research further develops, it is highly likely that the conversion efficiency of the perovskite solar cell will exceed that of a single crystalline silicon solar cell which is currently well developed. Among a new generation of photovoltaic technologies, a perovskite solar energy technology is likely to be the first to be industrialized.

Subcells inside the perovskite solar cell form a series structure after being subjected to P1, P2 and P3 scribing. Photoelectric output performance parameters (a current, a voltage, and a fill factor) of the perovskite solar cell depend on the characteristic of each subcell, so the design and structure of each subcell are critical to the performance of the perovskite solar cell. However, the subcells of the conventional perovskite solar cell have a current-limiting phenomenon due to factors such as equipment and a process, which reduces the conversion efficiency of the perovskite solar cell. CN114156411A discloses a thin-film solar cell with a plurality of sub-cells, a substrate, a first electrode and grid lines. CN113284957A discloses a solar cell where the area of the grid lines of the cell at the two ends of the cell is larger than that in the middle region of the cell.

### SUMMARY

Based on this, this application provides a solar cell and a preparation method therefor. The solar cell can improve a current-limiting phenomenon, thereby improving the conversion efficiency of the solar cell.

According to a first aspect, this application provides a solar cell. The solar cell includes:
a plurality of subcells, sequentially arranged in series in a first direction, where each of the subcells includes a substrate and a first electrode that are stacked; the plurality of subcells include two first subcells and at least one second subcell, and the at least one second subcell is located between the two first subcells; and the first direction is perpendicular to a thickness direction of the solar cell; and
a plurality of grid lines, disposed on the first electrodes of the subcells in a one-to-one correspondence mode, where an area of orthographic projections of the grid lines corresponding to the first subcells on the first subcells is greater than an area of an orthographic projection of the grid line corresponding to the second subcell on the second subcell.

According to the foregoing solar cell, the area of the orthographic projections of the grid lines on the first subcells on the first subcells is greater than the area of the orthographic projection of the grid line on the second subcell on the second subcell, so that a contact area between the grid lines on the first subcells and the first electrodes on the first subcells is greater than a contact area between the grid line on the second subcell and the first electrode on the second subcell. In this way, the grid lines on the first subcells may have a higher current collecting capacity than the grid line on the second subcell, thereby compensating for a low-output current caused by self-structures of the first subcells, which increases an output current on the first subcells, thus minimizing a difference between the output current of the first subcells and an output current of the second subcell, improving a current-limiting phenomenon cased by a mismatch between the output currents of the first subcells and the second subcell and improving the conversion efficiency of the solar cell.

In some embodiments, the plurality of grid lines include:
two first grid lines, where the first grid lines are disposed on the first electrodes of the first subcells; and each of the first grid lines includes a first bus and a plurality of first branch lines connected to the first bus, and the first branch lines are arranged on one side of the first bus at intervals; and
at least one second grid line, where the second grid line is disposed on the first electrode of the second subcell; and the second grid line includes a second bus and a plurality of second branch lines connected to the second bus, and the second branch lines are arranged on one side of the second bus at intervals.

In this way, the first grid lines are correspondingly disposed on the first subcells, the second grid line is correspondingly disposed on the second subcell, and by adjusting structures of the first grid lines and the second grid line, the first grid lines and the second grid line have different current collecting capacities.

In some embodiments, the number of the first branch lines in the first grid lines is greater than the number of the second branch lines in the second grid line; and a distance between any two adjacent first branch lines in the first grid lines is less than a distance between any two adjacent second branch lines in the second grid line.

In this way, an arrangement density of the first branch lines on the first grid lines is greater than an arrangement density of the second branch lines on the second grid line, so that the first grid lines have a higher current collecting capacity than the second grid line.

In some embodiments, an area of an orthographic projection of each of the first branch lines on the corresponding first subcell is equal to an area of an orthographic projection of each of the second branch lines on the corresponding second subcell.

In this way, the first branch lines may have the same size as the second branch lines, thereby reducing the preparation difficulty of the grid lines.

In some embodiments, an area of an orthographic projection of each of the first branch lines on the corresponding first subcell is greater than an area of an orthographic projection of each of the second branch lines on the corresponding second subcell.

In this way, a contact area between the first branch lines and the first electrodes is greater than a contact area between the second branch lines and the first electrode, so that the first grid lines have a higher current collecting capacity than the second grid line.

In some embodiments, in the thickness direction of the solar cell, a thickness of each of the first branch lines is equal to a thickness of each of the second branch lines.

In this way, the preparation difficulty of the grid lines may be reduced.

In some embodiments, thicknesses of the first branch lines and thicknesses of the second branch lines are greater than or equal to 20 nm and less than or equal to 200 nm; and widths of the first branch lines and widths of the second branch lines are greater than or equal to 20 µm and less than or equal to 100 µm.

In this way, in a case that the grid lines have a good current collecting capacity, on the one hand, it may be ensured that the grid lines have small resistance, and on the other hand, it may be ensured that the subcells have high light transmissivity.

In some embodiments, the plurality of subcells further include two third subcells, the two third subcells are located between the two first subcells, and each second subcell is located between the two third subcells; and
an area of orthographic projections of the grid lines corresponding to the third subcells on the third subcells is greater than the area of the orthographic projection of the grid line corresponding to the second subcell on the second subcell and less than the area of the orthographic projections of the grid lines corresponding to the first subcells on the first subcells.

In this way, a current collecting capacity of the grid lines on the third subcells may be improved, thereby compensating for a low current caused by self-structures of the third subcells, which increases an output current on the third subcells, so that the output currents on the first subcells, the second subcell and the third subcells are matched to the maximum extent, which improves a current-limiting phenomenon and improves the conversion efficiency of the solar cell.

In some embodiments, each of the subcells further includes a second electrode, a first charge transport layer, a light absorption layer and a second charge transport layer that are stacked on the corresponding substrate, the first electrode is disposed on a side of the second charge transport layer facing away from the substrate, and the corresponding grid line is disposed on a side of the first electrode facing away from the substrate. In this way, the structure of the solar cell may be more optimized, which reduces the preparation difficulty and has the high conversion efficiency.

In some embodiments, the light absorption layers include perovskite layers. In this way, such grid line structures may be applied to a perovskite cell to improve the conversion efficiency of the perovskite solar cell.

In some embodiments, extension lines are disposed in the subcells; and one end of each of the extension lines is connected to the grid line on the corresponding subcell, and the other end of each of the extension lines is connected to the second electrode of the adjacent subcell. In this way, the adjacent subcells may be connected in series through the extension lines.

According to a second aspect, this application provides a preparation method for a solar cell. The preparation method includes:
forming a first electrode on a substrate; and
forming a plurality of grid lines on the first electrode, and forming a plurality of subcells, where the plurality of subcells are sequentially arranged in series in a first direction; the plurality of subcells include two first subcells and at least one second subcell, and the at least one second subcell is located between the two first subcells; the grid lines correspond to the subcells one to one, and an area of orthographic projections of the grid lines corresponding to the first subcells on the first subcells is greater than an area of an orthographic projection of the grid line corresponding to the second subcell on the second subcell; and the first direction is perpendicular to a thickness direction of the solar cell.

According to the foregoing preparation method for the solar cell, the area of the orthographic projections of the grid lines on the first subcells on the first subcells is greater than the area of the orthographic projection of the grid line on the second subcell on the second subcell, so that a contact area between the grid lines on the first subcells and the first electrodes on the first subcells is greater than a contact area between the grid line on the second subcell and the first electrode on the second subcell. In this way, the grid lines on the first subcells may have a higher current collecting capacity than the grid line on the second subcell, thereby compensating for a low-output current caused by self-structures of the first subcells, which increases an output current on the first subcells, thus minimizing a difference between the output current of the first subcells and an output current of the second subcell, improving a current-limiting phenomenon cased by a mismatch between the output currents of the first subcells and the second subcell and improving the conversion efficiency of the solar cell.

The above description is only an overview of the technical solutions of this application, in order to be able to more clearly understand the technical means of this application, the technical solutions may be implemented in accordance with the contents of the specification, and in order to make the above and other objectives, features and advantages of this application more apparent and understandable, the specific implementations of this application are thereby listed.

### BRIEF DESCRIPTION OF DRAWINGS

In order to more clearly illustrate the technical solutions of the embodiments of this application, the following will briefly introduce the drawings that are desired to be used in the embodiments of this application. Apparently, the drawings described below are merely some embodiments of this application, from which other drawings may be obtained by a person of ordinary skill in the art without creative work.
FIG. 1 is a schematic diagram of a local structure of a solar cell in the related art;
FIG. 2 is a schematic top view of a solar cell according to an embodiment of this application;
FIG. 3 is a schematic diagram of a sectional structure of the solar cell in FIG. 2;
FIG. 4 is a schematic top view of another solar cell according to an embodiment of this application;
FIG. 5 is a schematic top view of yet another solar cell according to an embodiment of this application;
FIG. 6 is a flow chart of a preparation method for a solar cell according to an embodiment of this application;
FIG. 7 is a schematic structural diagram after P1 etching in a preparation method for a solar cell according to an embodiment of this application;
FIG. 8 is a schematic structural diagram after P2 etching in a preparation method for a solar cell according to an embodiment of this application; and
FIG. 9 is a schematic structural diagram after grid line formation in a preparation method for a solar cell according to an embodiment of this application.
1. Perovskite solar cell; 11. Glass base; 12. Conductive film; 13. Electron transport layer; 14. Perovskite light absorption layer; 15. Hole transport layer; 16. Metal layer; 2. Solar cell; 21. Subcell; 21a. First subcell; 21b. Second subcell; 21c. Third subcell; 211. Substrate; 212. First electrode; 213. Second electrode; 214. First charge transport layer; 215. Light absorption layer; 216. Second charge transport layer; 22. Grid line; 221. First grid line; 2211. First bus; 2212. First branch line; 222. Second grid line; 2221. Second bus; 2222. Second branch line; 223. Third grid line; 2231. Third bus; 2232. Third branch line; 224. Extension line; 231. First trench; 232. Second trench; and 233. Third trench.

### DETAILED DESCRIPTION OF EMBODIMENTS

The following describes in detail the embodiments of the technical solutions of this application with reference to the accompanying drawings. The following embodiments are merely intended for a clearer description of the technical solutions of this application and therefore are used as just examples which do not constitute any limitation on the protection scope of this application.

Unless otherwise defined, all technical and scientific terms used herein shall have the same meanings as commonly understood by persons skilled in the art to which this application belongs. The terms used herein are intended to merely describe the specific embodiments rather than to limit this application. The terms "comprise", "include", and any other variations thereof in the specification, claims and brief description of drawings of this application are intended to cover non-exclusive inclusions.

In the description of the embodiments of this application, the technical terms "first", "second", and the like are merely used to distinguish between different objects, and shall not be construed as any indication or implication of relative importance or any implicit indication of the quantity, particular sequence or primary-secondary relationship of the technical features indicated. In the description of the embodiments of this application, "a plurality of" means two or more unless otherwise expressly and specifically defined.

In this specification, reference to "embodiment" means that specific features, structures or characteristics described with reference to the embodiment may be incorporated in at least one embodiment of this application. The word "embodiment" appearing in various positions in the specification does not necessarily refer to the same embodiment or an independent or alternative embodiment that is exclusive of other embodiments. It is explicitly or implicitly understood by persons skilled in the art that the embodiments described herein may be combined with other embodiments. In the descriptions of the embodiments of this application, the term "and/or" describes only an association relationship for describing associated objects and represents that three relationships may exist. For example, A and/or B may represent: the following three cases: only A alone, both A and B, and only B alone. In addition, the character "/" in this specification generally indicates an "or" relationship between contextually associated objects.

In the description of the embodiments of this application, the term "a plurality of" refers to two or more (including two), similarly, "a plurality of groups" refers to two or more groups (including two groups), and "a plurality of pieces" refers to two or more pieces (including two pieces).

In the description of the embodiments of this application, the orientation or positional relationships indicated by the technical terms "center", "longitudinal", "transverse", "length", "width", "thickness", "upper", "lower", "front", "rear", "left", "right", "vertical", "horizontal", "top", "bottom", "inner", "outer", "clockwise", "anticlockwise", "axial", "radial", "circumferential", etc. are based on the orientation or positional relationships shown in the drawings, merely to facilitate the description of the embodiments of this application and simplify the description, and do not indicate or imply that the device or element referred to must have a particular orientation, be constructed and operated in a particular orientation, and thus should not be construed as limiting the embodiments of this application.

In the description of the embodiments of this application, unless otherwise expressly specified and limited, the technical terms "mounted", "connected", "connect", "fixed" and the like are to be understood in a broad sense, for example, it may be a fixed connection, or a detachable connection, or an integral connection; it may also be a mechanical connection or an electrical connection; and it may be a direct connection or indirect connection through an intermediate medium, and may be the interior communication between two elements or the interaction relationship between two elements. For a person of ordinary skill in the art, the specific meaning of the above-mentioned terms in the embodiments of this application may be understood according to specific circumstances.

Since a perovskite solar cell was first reported in 2009, it has been favored by researchers for its ultra-low material cost and solution preparation process, and the energy conversion efficiency of the perovskite solar cell with a small area (less than 1 cm²) has been increased from initial 3.8% to 25.8%. As the research further develops, it is highly likely that the conversion efficiency of the perovskite solar cell will exceed that of a single crystalline silicon solar cell which is currently well developed.

Among a new generation of photovoltaic technologies, a perovskite solar energy technology is likely to be the first to be industrialized.

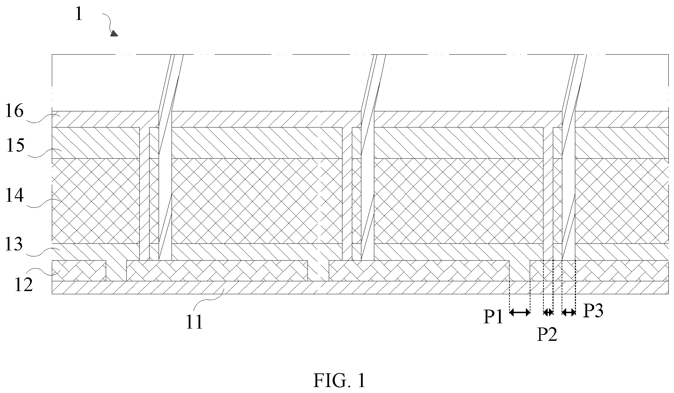

Specifically, as shown FIG. 1, a perovskite solar cell 1 includes a glass base 11, a conductive film 12, an electron transport layer 13, a perovskite light absorption layer 14, a hole transport layer 15 and a metal layer 16 that are stacked. Subcells inside the perovskite solar cell 1 form a series structure after being subjected to P1, P2 and P3 scribing. Photoelectric output performance parameters (a current, a voltage, and a fill factor) of the perovskite solar cell 1 depend on the characteristic of each subcell, so the design and structure of each subcell are critical to the performance of the perovskite solar cell 1.

Large coating equipment is typically used in a preparation process of the perovskite solar cell 1. Spatial distribution of process parameters such as a process gas, a temperature, an electromagnetic field, a plasma, a target material, and an evaporation source of the large coating equipment is nonuniform, leading to poor thickness uniformity of the perovskite light absorption layer 14. Generally, subcells at an edge region have a thinner perovskite light absorption layer 14 than subcells in a middle region, so that the subcells at the edge region have poorer performance than the subcells in the middle region, which is specifically shown as follows: the subcells at the edge region have an output current less than the subcells in the middle region. Thus, a mismatch between the output currents of the subcells at the edge region and the subcells in the middle region is caused, which produces a current-limiting phenomenon and reduces the conversion efficiency of the perovskite solar cell 1.

In order to alleviate the foregoing problems, the applicant found through research that by increasing a current collecting capacity of grid lines of the subcells at the edge region, a low-output current caused by self-structures of the subcells at the edge region can be compensated for, which increases an output current of the subcells at the edge region, thus minimizing a difference between the output current of the subcells at the edge region and an output current of the subcells in the middle region, improving the current-limiting phenomenon cased by the mismatch between the output currents of the subcells at the edge region and the subcells in the middle region and improving the conversion efficiency of the solar cell.

The solar cell disclosed in the embodiment of this application may be, but is not limited to, used in a transportation field, a communications/telecommunication field, an oil or marine field, and a household lamp field. The transportation field includes, for example, a navigation lamp, a traffic/railway signal lamp, a traffic warning/marker lamp, a Yuxiang street lamp, an aviation obstruction lamp, an expressway/railway radio telephone booth, and an unattended railway or highway maintenance squad power supply. The communications/telecommunication field includes, for example, a solar unattended microwave relay station, an optical cable maintenance station, a broadcast/communication/paging power system, a rural carrier telephone photovoltaic system, a small communicator, and a soldier GPS power supply. The oil or marine field includes, for example, an oil pipeline and reservoir gate cathodic protection solar power supply system, an oil drilling platform domestic and emergency power supply, and marine detection equipment. The household lamp field includes, for example, a yard lamp, a street lamp, a hand lamp, a camping lamp, a mountain climbing lamp, a fishing lamp, a black light lamp, a rubber tapping lamp, and an energy saving lamp.

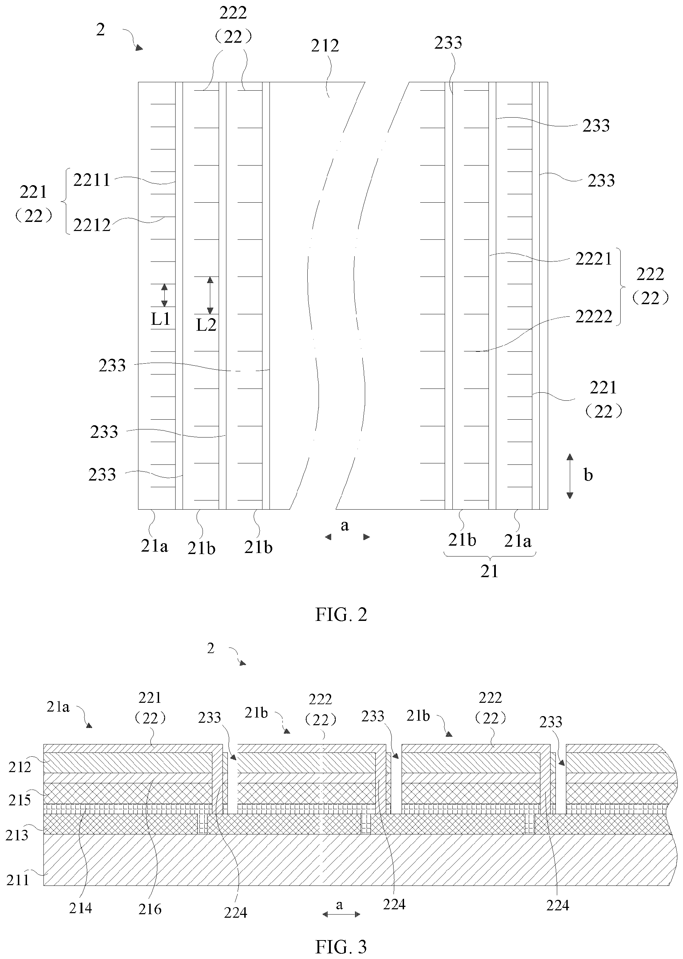

According to a first aspect, as shown in FIG. 2 and FIG. 3, an embodiment of this application provides a solar cell 2. The solar cell 2 includes a plurality of subcells 21 and a plurality of grid lines 22.

The plurality of subcells 21 are sequentially arranged in a first direction a, and mutually connected in series. The first direction a is perpendicular to a thickness direction of the solar cell 2. Each of the subcells 21 includes a substrate 211 and a first electrode 212 that are stacked, and the substrate 211 may be a glass base or a polyethylene glycol terephthalate (PET) base. The plurality of subcells 21 include two first subcells 21a and at least one second subcell 21b, and the at least one second subcell 21b is located between the two first subcells 21a. It may be understood that there may be a plurality of second subcells 21b, and the plurality of second subcells 21b are arranged between the two first subcells 21a at intervals.

The plurality of grid lines 22 are disposed on the first electrodes 212 of the subcells 21 in a one-to-one correspondence mode. An area of orthographic projections of the grid lines 22 on the first subcells 21a on the first electrodes 212 of the first subcells 21a is greater than an area of an orthographic projection of the grid line 22 on the second subcell 21b on the first electrode 212 of the second subcell 21b. The orthographic projections herein refer to: orthographic projections of the grid lines 22 on the first electrodes 212 in the thickness direction of the solar cell 2.

The subcells 21 refer to minimum cell units that constitute the solar cell 2. The first subcells 21a refer to subcells 21 that are located at an edge region of the solar cell 2, and the second subcell 21b refers to a subcell 21 that is located at a non-edge region (middle region) of the solar cell 2. The grid lines 22 refer to conductive metals for collecting currents on the first electrodes 212. The grid lines 22 may be made of any one of metals such as gold, silver, copper, aluminum, nickel, zinc, tin and iron, or alloy including the foregoing metals. The first electrodes 212 refer to front electrodes or back electrodes that constitute the subcells 21. In the embodiment of this application, the first electrodes 212 refer to the back electrodes, and the grid lines 22 are disposed on the back electrodes.

The foregoing arrangement is equivalent to making a contact area between the grid lines 22 on the first subcells 21a and the first electrodes 212 on the first subcells 21a greater than a contact area between the grid line 22 on the second subcell 21b and the first electrode 212 on the second subcell 21b. It may be understood that the greater the contact area between the grid lines 22 and the first electrodes 212 is, the higher the capacity of the grid lines 22 to collect currents will be. Therefore, the grid lines 22 on the first subcells 21a may have a higher current collecting capacity than the grid line 22 on the second subcell 21b, thereby compensating for a low-output current caused by self-structures of the first subcells 21a, which increases an output current on the first subcells 21a, thus minimizing a difference between the output current of the first subcells 21a and an output current of the second subcell 21b, improving a current-limiting phenomenon cased by a mismatch between the output currents of the first subcells 21a and the second subcell 21b and improving the conversion efficiency of the solar cell 2.

In some embodiments, the grid lines 22 include two first grid lines 221 and at one second grid line 222. The first grid lines 221 are disposed on the first electrodes 212 of the first subcells 21a, and the second grid line 222 is disposed on the first electrode 212 of the second subcell 21b.

The first grid lines 221 refer to grid lines 22 that are disposed on the first electrodes 212 of the first subcells 21a. The second grid line 222 refers to a grid line 22 that is disposed on the first electrode 212 of the second subcell 21b.

In this way, the first grid lines 221 are correspondingly disposed on the first subcells 21a, the second grid line 222 is correspondingly disposed on the second subcell 21b, and by adjusting structures of the first grid lines 221 and the second grid line 222, the first grid lines 221 and the second grid line 222 have different current collecting capacities.

As an embodiment, each of the first grid lines 221 includes a first bus 2211 and a plurality of first branch lines 2212 connected to the first bus 2211, and the first branch lines 2212 are uniformly arranged on one side of the first bus 2211. The second grid line 222 includes a second bus 2221 and a plurality of second branch lines 2222 connected to the second bus 2221, and the second branch lines 2222 are uniformly arranged on one side of the second bus 2221.

The first buses 2211 are equivalent to "buses" on the first grid lines 221, and the first branch lines 2212 are equivalent to "branch lines" on the first grid lines 221. The second bus 2221 is equivalent to a "bus" on the second grid line 222, and the second branch lines 2222 are equivalent to "branch lines" on the second grid line 222. The first branch lines 2212 and the second branch lines 2222 are mainly configured to collect currents on the first electrodes 212. The first branch lines 2212 collect currents and then gather the currents to the first buses 2211, and the first buses 2211 transfer the currents out. The second branch lines 2222 collect currents and gather the currents to the second bus 2221, and the second bus 2221 transfers the currents out.

It may be understood that both sides of the first buses 2211 in the first direction a may be provided with the first branch lines 2212. Similarly, both sides of the second bus 2221 in the first direction a may be provided with the second branch lines 2222.

As an embodiment, both the first branch lines 2212 and the second branch lines 2222 extend in the first direction a, an extending direction of the first buses 2211 is perpendicular to an extending direction of the first branch lines 2212, and an extending direction of the second bus 2221 is perpendicular to an extending direction of the second branch lines 2222. In this way, on the one hand, the grid lines 22 may be relatively regular, and on the other hand, the preparation difficulty of the grid lines 22 may be reduced.

In some embodiments, the number of the first branch lines 2212 in the first grid lines 221 is greater than the number of the second branch lines 2222 in the second grid line 222. A distance L1 between any two adjacent first branch lines 2212 in the first grid lines 221 is less than a distance L2 between any two adjacent second branch lines 2222 in the second grid line 222.

In this way, it is equivalent to making an arrangement density of the first branch lines 2212 on the first grid lines 221 greater than an arrangement density of the second branch lines 2222 on the second grid line 222. Since there are more first branch lines 2212 on the first grid lines 221 and there is a less distance between the adjacent first branch lines 2212, the first grid lines 221 have a higher current collecting capacity than the second grid line 222.

In some embodiments, an area of an orthographic projection of each of the first branch lines 2212 on the first electrode 212 of the corresponding first subcell 21a is equal to an area of an orthographic projection of each of the second branch lines 2222 on the first electrode 212 of the corresponding second subcell 21b.

It may be understood that: a contact area between the first branch lines 2212 and the first electrodes 212 is equivalent to a contact area between the second branch lines 2222 and the first electrodes 212. In the embodiment of this application, the first branch lines 2212 and the second branch lines 2222 have the same shapes and sizes. In this way, the preparation difficulty of a mask may be reduced, thereby reducing the preparation difficulty of the grid lines 22. In another example, the first branch lines 2212 and the second branch lines 2222 have different shapes and sizes, and it also may be ensured that a contact area between the first branch lines 2212 and the first electrodes 212 is equal to a contact area between the second branch lines 2222 and the first electrodes 212.

In the embodiment of this application, since the first branch lines 2212 and the second branch lines 2222 have the same shapes and sizes, the number of the first branch lines 2212 in the first grid lines 221 may be greater than the number of the second branch lines 2222 in the second grid line 222, so that the first grid lines 221 have a higher current collecting capacity than the second grid line 222.

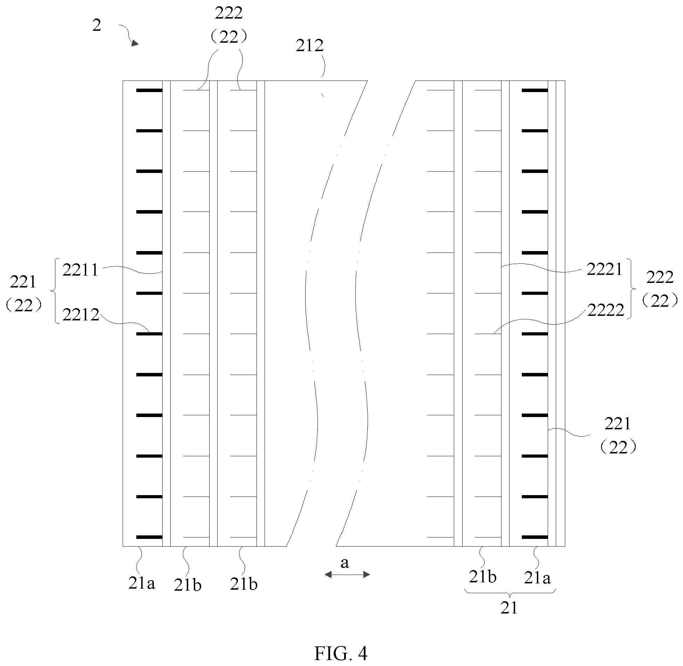

In some embodiments, as shown in FIG. 4, an area of an orthographic projection of each of the first branch lines 2212 on the first electrode 212 of the corresponding first subcell 21a is greater than an area of an orthographic projection of each of the second branch lines 2222 on the first electrode 212 of the corresponding second subcell 21b.

It may be understood that: a contact area between the first branch lines 2212 and the first electrodes 212 is greater than a contact area between the second branch lines 2222 and the first electrodes 212.

Specifically, the first branch lines 2212 may have a width equal to the second branch lines 2222 in a second direction b and have a length greater than the second branch lines 2222 in the first direction a; or the first branch lines 2212 may have a length equal to the second branch lines 2222 in the first direction a and have a width greater than the second branch line 2222 in the second direction b. The embodiment of this application does not limit the specific structures of the first branch lines 2212 and the second branch lines 2222.

In an example, when a contact area between the first branch lines 2212 and the corresponding first electrodes 212 is greater than a contact area between the second branch lines 2222 and the corresponding first electrode 212, the number of the first branch lines 2212 in the first grid lines 221 may be equal to the number of the second branch lines 2222 in the second grid line 222. In this way, in a case that the number of the first branch lines 2212 in the first grid lines 221 is equal to that of the second branch lines 2222 in the second grid line 222, the first grid lines 221 have a higher current collecting capacity than the second grid line 222.

In another example, when the contact area between the first branch lines 2212 and the corresponding first electrodes 212 is greater than the contact area between the second branch lines 2222 and the corresponding first electrode 212, the number of the first branch lines 2212 in the first grid lines 221 may also be greater than the number of the second branch lines 2222 in the second grid line 222. In this way, the first grid lines 221 may further have a higher current collecting capacity than the second grid line 222.

In yet another example, when the contact area between the first branch lines 2212 and the corresponding first electrodes 212 is greater than the contact area between the second branch lines 2222 and the corresponding first electrode 212, the number of the first branch lines 2212 in the first grid lines 221 may further be less than the number of the second branch lines in the second grid line 222. However, it is necessary to ensure that the contact area between the first grid lines 221 and the corresponding first electrodes 212 is greater than the contact area between the second grid line 222 and the corresponding first electrode 212, so that the first grid lines 221 have a higher current collecting capacity than the second grid line 222.

The contact area between the first branch lines 2212 and the first electrodes 212 is greater than the contact area between the second branch lines 2222 and the first electrode 212, so that the first branch lines 2212 in the first grid lines 221 may have a higher current collecting capacity than the second branch lines 2222 in the second grid line 222, and thus the first grid lines 221 have a higher current collecting capacity than the second grid line 222.

In some embodiments, in the thickness direction of the solar cell 2, a thickness of each of the first branch lines 2212 is equal to a thickness of each of the second branch lines 2222.

In this way, on the one hand, when the grid lines 22 are prepared, the first branch lines 2212 and the second branch lines 2222 with uniform thicknesses may be formed through a single process, thereby avoiding the first branch lines 2212 and the second branch lines 2222 from being formed through multiple processes respectively, and reducing the preparation difficulty of the grid lines; and on the other hand, in a case that the first branch lines 2212 and the second branch lines 2222 have the same shape, it may be ensured that the first branch lines 2212 and the second branch lines 2222 have the same resistance, so that the first branch lines 2212 and the second branch lines 2222 have the same current loss.

In some embodiments, thicknesses of the first branch lines 2212 and thicknesses of the second branch lines 2222 are greater than or equal to 20 nm and less than or equal to 200 nm. Widths of the first branch lines 2212 and widths of the second branch lines 2222 are greater than or equal to 20 µm and less than or equal to 100 µm. Specifically, taking the first branch lines 2212 as an example, the thicknesses of the first branch lines 2212 refer to: distances between upper surfaces and lower surfaces of the first branch lines 2212 in the thickness direction of the solar cell 2. Exemplarily, the thicknesses of the first branch lines 2212 may be 20 nm, 30 nm, 50 nm, 100 nm, 150 nm, 175 nm, 190 nm, or 200 nm. The widths of the first branch lines 2212 refer to lengths of the first branch lines 2212 in the second direction b. The second direction b is perpendicular to the first direction a. Exemplarily, the widths of the first branch lines 2212 may be 20 µm, 30 µm, 50 µm, 60 µm, 80 µm, 90 µm, or 100 µm. The thicknesses of the first branch lines 2212 and the second branch lines 2222 are within the foregoing range, in a case of ensuring that the solar cell 2 has a small thickness, the first branch lines 2212 and the second branch lines 2222 may have a certain structural strength, thereby avoiding the first branch lines 2212 and the second branch lines 2222 from being broken. The widths of the first branch lines 2212 and the second branch lines 2222 are within the foregoing range, on the one hand, it may be ensured that the first branch lines 2212 and the second branch lines 2222 have a good current collecting capacity, and on the other hand, it may be ensured that the subcells 21 have certain light transmissivity. At the same time, the above arrangement may make the first branch lines 2212 and the second branch lines 2222 have small resistance and less current losses, thereby improving the conversion efficiency of the solar cell 2.

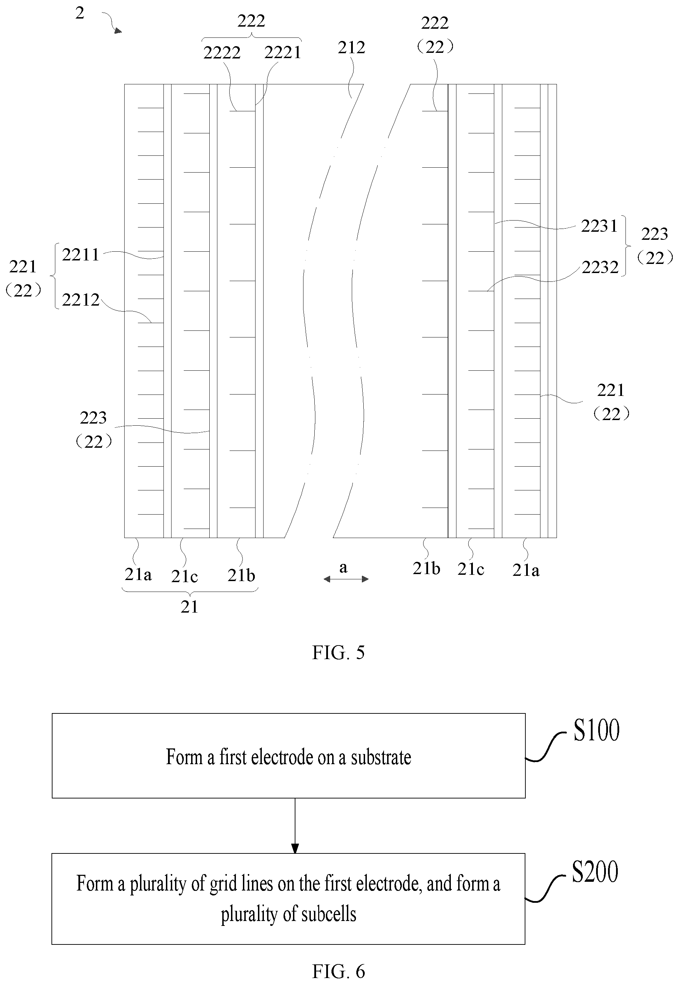

In some embodiments, as shown in FIG. 5, the plurality of subcells 21 further include two third subcells 21c, each second subcell 21b is located between the two third subcells 21c, and the two third subcells 21c are located between the two first subcells 21a.

It may be understood that: the first subcells 21a are located at the edge region of the solar cell 2, the second subcell 21b is located in the middle region of the solar cell 2, and the third subcells 21c are located at a transition region between the edge region and the middle region. Due to the influence of a preparation process, the performance sequence of the first subcells 21a, the second subcell 21b and the third subcells 21c is as follows: the second subcell 21b > the third subcells 21c > the first subcells 21a. As an embodiment, an area of orthographic projections of the grid lines 22 corresponding to the third subcells 21c on the first electrodes 212 of the third subcells 21c is greater than the area of the orthographic projection of the grid line 22 corresponding to the second subcell 21b on the first electrode 212 of the second subcell 21b and less than the area of the orthographic projections of the grid lines 22 corresponding to the first subcells 21a on the first electrode 212 of the first subcells 21a.

As an embodiment, the grid lines 22 may include third grid lines 223, and the third grid lines 223 are disposed on the first electrodes 212 of the third subcells 21c. Each of the third grid lines 223 includes a third bus 2231 and a plurality of third branch lines 2232 connected to the third bus 2231, and the third branch lines 2232 are uniformly arranged on one side of the third bus 2231. A contact area between the third grid lines 223 and the first electrodes 212 on the third subcells 21c is greater than the contact area between the second grid line 222 and the first electrode on the second subcell 21b and less than the contact area between the first grid lines 221 and the first electrodes 212 on the first subcells 21a.

In this way, the current collecting capacity of the third grid lines 223 may be improved, thereby compensating for a low current caused by self-structures of the third subcells 21c, which increases an output current on the third subcells 21c, so that the output currents on the first subcells 21a, the second subcell 21b and the third subcells 21c are matched to the maximum extent, which improves a current-limiting phenomenon and improves the conversion efficiency of the solar cell 2.

It is hereby noted that the third grid lines 223 may be arranged in the same way as the first grid lines 221, which will not be described in detail in the embodiment of this application.

In some embodiments, as shown in FIG. 3, each of the subcells 21 further includes a second electrode 213, a first charge transport layer 214, a light absorption layer 215 and a second charge transport layer 216 that are stacked on the corresponding substrate 211, the first electrode 212 is disposed on a side of the second charge transport layer 216 facing away from the substrate 211, and the corresponding grid line 22 is disposed on a side of the first electrode 212 facing away from the substrate 211. In this way, the structure of the solar cell 2 may be more optimized, which reduces the preparation difficulty and has the high conversion efficiency.

The first electrodes 212 and the second electrodes 213 may be made of a conducting oxide, such as indium tin oxide (ITO), antimony tin oxide (AZO), boron-doped zinc oxide (BZO), and indium zinc oxide (IZO).

As an embodiment, the solar cell 2 is of a trans structure, the first charge transport layers 214 are hole transport layers, and the first charge transport layers 214 include all organic or inorganic materials that may be used as the hole transport layers. The second charge transport layers 216 are electron transport layers, and the second charge transport layers 216 include all organic or inorganic materials that may be used as the electron transport layers.

As an embodiment, the solar cell 2 is of a cis structure, the first charge transport layers 214 are electron transport layers, and the first charge transport layers 214 include all organic or inorganic materials that may be used as the electron transport layers. The second charge transport layers 216 are hole transport layers, and the second charge transport layers 216 include all organic or inorganic materials that may be used as the hole transport layers.

In some embodiments, the light absorption layers 215 include perovskite layers. In this way, such grid line 22 structures may be applied to perovskite cells so as to improve the conversion efficiency of the perovskite solar cell 2.

In some embodiments, as shown in FIG. 3, extension lines 224 are further disposed in the subcells 21. One end of each of the extension lines 224 is connected to the grid line 22 on the corresponding subcell 21, and the other end of each of the extension lines 224 is connected to the second electrode 213 of the subcell 21 adjacent to the corresponding subcell 21.

The extension lines 224 refer to conductive metals extending in the thickness direction of the solar cell 2, and the extension lines 224 may be considered as parts of the grid lines 22. Each of the extension lines 224 primarily serves to connect every two adjacent subcells 21 in series.

Through the foregoing arrangement in which the extension lines 224 connect the adjacent subcells 21 in series, the plurality of subcells 21 may be overall connected in series.

In some embodiments, as shown in FIG. 2, the grid lines 22 include two first grid lines 221 and at least one second grid line 222. The first grid lines 221 are disposed on the first electrodes 212 of the first subcells 21a, and the second grid line 222 is disposed on the first electrode 212 of the second subcell 21b. Each of the first grid lines 221 includes a first bus 2211 and a plurality of first branch lines 2212 connected to the first bus 2211, and the first branch lines 2212 are uniformly arranged on one side of the first bus 2211. The second grid line 222 includes a second bus 2221 and a plurality of second branch lines 2222 connected to the second bus 2221, and the second branch lines 2222 are uniformly arranged on one side of the second bus 2221. The number of the first branch lines 2212 in the first grid lines 221 is greater than the number of the second branch lines 2222 in the second grid line 222. A distance L1 between any two adjacent first branch lines 2212 in the first grid lines 221 is less than a distance L2 between any two adjacent second branch lines 2222 in the second grid line 222. An area of an orthographic projection of each of the first branch lines 2212 on the first electrode 212 of the corresponding first subcell 21a is equal to an area of an orthographic projection of each of the second branch lines 2222 on the first electrode 212 of the corresponding second subcell 21b. Specifically, the first branch lines 2212 and the second branch lines 2222 have the same shapes, sizes and thicknesses.

In this way, on the one hand, it is equivalent to making an arrangement density of the first branch lines 2212 on the first grid lines 221 greater than an arrangement density of the second branch lines 2222 on the second grid line 222. Since there are more first branch lines 2212 on the first grid lines 221, the first grid lines 221 have a higher current collecting capacity than the second grid line 222. On the other hand, the "branch lines" of all the grid lines 22 may have the same sizes to facilitate preparation of the grid lines 22.

According to a second aspect, referring to FIG. 6 and in conjunction with FIG. 3, an embodiment of this application provides a preparation method for a solar cell. The method includes:
S100: Form a first electrode on a substrate. The substrate 211 may be a glass substrate or a PET substrate. The first electrode 212 may be made of a conducting oxide, such as indium tin oxide (ITO), antimony tin oxide (AZO), boron-doped zinc oxide (BZO), and indium zinc oxide (IZO). The first electrode 212 may be prepared through processes such as vacuum sputtering, reactive plasma sputtering coating, or atomic layer deposition.

S200: Form a plurality of grid lines on the first electrode, and form a plurality of subcells. The subcells 21a are sequentially arranged in a first direction a, and are mutually connected in series. The plurality of subcells 21a include two first subcells 21a and at least one second subcell 21b, and each second subcell 21b is located between the two first subcells 21a. The grid lines 22 correspond to the subcells 21a one to one. An area of orthographic projections of the grid lines 22 corresponding to the first subcells 21a on the first electrodes 212 of the first subcells 21a is greater than an area of an orthographic projection of the grid line 22 corresponding to the second subcell 21b on the first electrode 212 of the second subcell 21b. The first direction a is perpendicular to a thickness direction of the solar cell 2.

According to the foregoing preparation method for the solar cell, the area of the orthographic projections of the grid lines 22 on the first subcells 21a on the first subcells 21a is greater than the area of the orthographic projection of the grid line 22 on the second subcell 21b on the second subcell 21b, so that a contact area between the grid lines 22 on the first subcells 21a and the first electrodes 212 on the first subcells 21a is greater than a contact area between the grid line 22 on the second subcell 21b and the first electrode 212 on the second subcell 21b. In this way, the grid lines 22 on the first subcells 21a may have a higher current collecting capacity than the grid line 22 on the second subcell 21b, thereby compensating for a low-output current caused by self-structures of the first subcells 21a, which increases an output current on the first subcells 21a, thus minimizing a difference between the output current of the first subcells 21a and an output current of the second subcell 21b, improving a current-limiting phenomenon cased by a mismatch between the output currents of the first subcells 21a and the second subcell 21b and improving the conversion efficiency of the solar cell 2.

As an embodiment, before step S100 where a first electrode is formed on a substrate, the preparation method further includes:
S70: Form a second electrode on the substrate. The second electrode 213 may be made of a conductive oxide, such as indium tin oxide (ITO), antimony tin oxide (AZO), boron-doped zinc oxide (BZO), and indium zinc oxide (IZO).

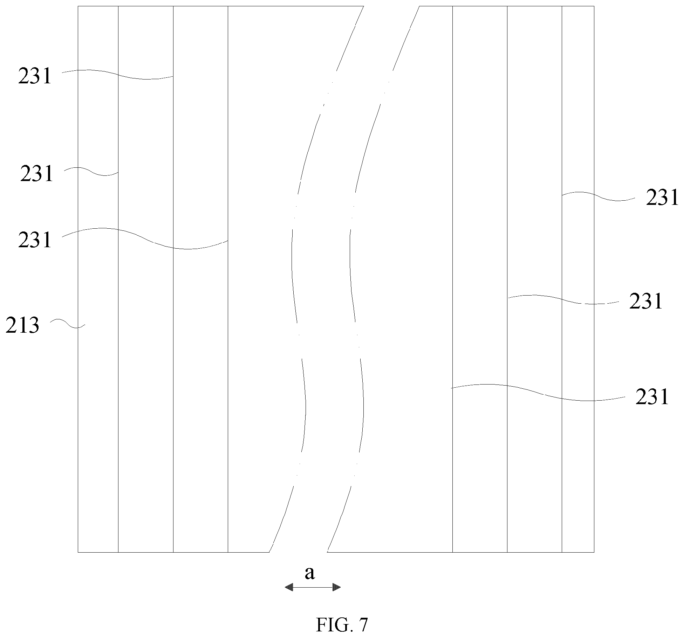

S80: Perform P1 scribing and etching on the second electrode to form a first trench. In the first direction a, scribing is performed every 6 µm to 10 mm, and a scribing width ranges from 10 µm to 80 µm. The structure after P1 scribing and etching is shown as FIG. 7. It is hereby noted that P1 scribing and etching may use laser etching or mechanical etching. Taking laser etching as an example, when P1 scribing and etching are performed, a laser device has a power of 3 W, a frequency of 145 KHz, and a rate of 1000 mm/s.

S90: Sequentially form a first charge transport layer, a light absorption layer and a second charge transport layer on the second electrode. Preparation methods for the first charge transport layer 214 and the second charge transport layer 216 may be vacuum sputtering, reactive plasma sputtering coating, vacuum thermal evaporation or wet coating, or the like. The light absorption layer 215 may be made of perovskite, and the light absorption layer 215 may be prepared using a wet coating process.

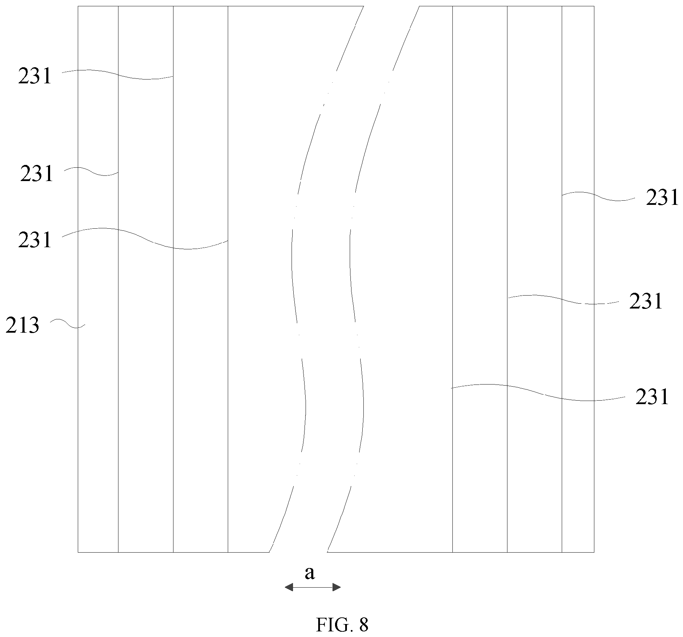

As an embodiment, step S200 where a plurality of grid lines are formed on the first electrode, and a plurality of subcells are formed specifically includes:
S210: Perform P2 scribing and etching on the first electrode to form a second trench. A P2 scribing width ranges from 50 µm to 150 µm. A distance between the second trench 232 and the first trench 231 in the first direction a ranges from 10 µm to 80 µm. The structure after P2 scribing and etching is as shown FIG. 8. It is hereby noted that P2 scribing and etching may use laser etching or mechanical etching. Taking laser etching as an example, when P2 scribing and etching are performed, a laser device has a power of 1 W, a frequency of 300 KHz, and a rate of 500 mm/s.

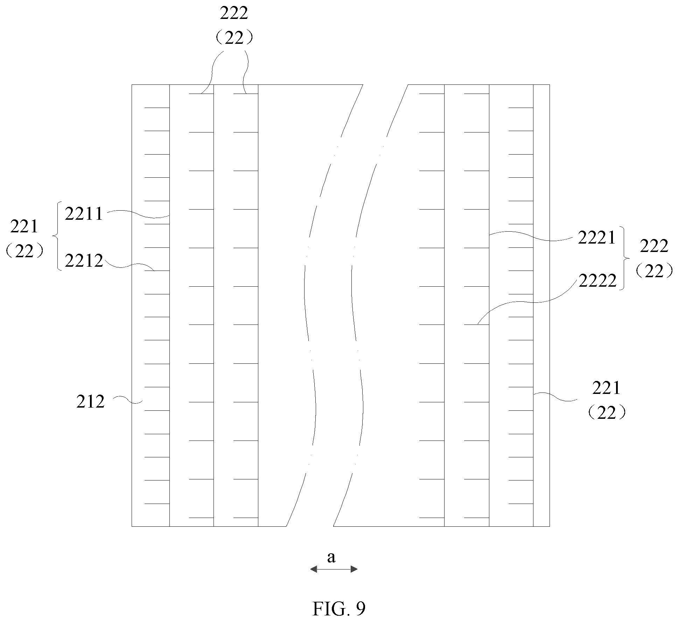

S220: Form the plurality of grid lines on the first electrode. The grid lines 22 may be made of any one of metals such as gold, silver, copper, aluminum, nickel, zinc, tin and iron, or alloy including the foregoing metals. The structure after the grid lines 22 are formed is as shown in FIG. 9. The grid lines 22 may be prepared through processes such as silk-screen printing, vacuum sputtering, or vacuum evaporation. Taking vacuum sputtering as an example, a sputtering power is 500 W, a working air pressure is 0.06 Pa, a target-substrate distance is 9 cm, and a deposition rate is 30 nm/s. Taking vacuum sputtering as an example, a working air pressure is 5×10⁻⁴ Pa, and a deposition rate is 3 nm/s. It may be understood that when the grid lines 22 are formed, the second trench 232 is filled with part of a metal, thereby electrically connecting the first electrode 212 to the second electrode 213.

S230: Perform P3 scribing and etching on the first electrode to form a third trench, thereby dividing the solar cell into a plurality of subcells. A P3 scribing width ranges from 20 µm to 200 µm, and a distance between the third trench 233 and the first trench 231 in the first direction a ranges from 0 µm to 200 µm. It is hereby noted that P3 scribing and etching may use laser etching or mechanical etching. Taking laser etching as an example, when P3 scribing and etching are performed, a laser device has a power of 1 W, a frequency of 600 KHz, and a rate of 600 mm/s. The structure after the third trench 233 is formed is as shown in FIG. 2.

It may be understood that, after step S230 where P3 scribing and etching are performed on the first electrode to form a third trench, thereby dividing the solar cell into a plurality of subcells, the solar cell 2 may further be subjected to processes such as edge clearing, testing, laminating and packaging to obtain a finished solar cell. Finally, it should be noted that: The foregoing embodiments are merely intended to describe the technical solutions of this application rather than to limit the technical solutions. This application is not limited to the specific embodiments disclosed in this specification, but includes all technical solutions falling within the scope of the claims.

## Claims

1. A solar cell (2), comprising:
a plurality of subcells (21), sequentially arranged in series in a first direction, wherein each of the subcells (21) comprises a substrate (211) and a first electrode (212) that are stacked; the plurality of subcells (21) comprise two first subcells (21a) and at least one second subcell (21b), and the at least one second subcell (21b) is located between the two first subcells (21a); and the first direction is perpendicular to a thickness direction of the solar cell (2); and
a plurality of grid lines (22), disposed on the first electrodes (212) of the subcells (21) in a one-to-one correspondence mode, **characterized in that** off an area of orthographic projections of the grid lines (22) corresponding to the first subcells (21a) on the first subcells (21a) is greater than an area of an orthographic projection of the grid line (22) corresponding to the second subcell (21b) on the second subcell (21b).

2. The solar cell (2) according to claim 1, **characterized in that** the plurality of grid lines (22) comprise:
two first grid lines (221), wherein the first grid lines (221) are disposed on the first electrodes (212) of the first subcells (21a); and each of the first grid lines (221) comprises a first bus (2211) and a plurality of first branch lines (2212) connected to the first bus (2211), and the first branch lines (2212) are arranged on one side of the first bus (2211) at intervals; and
at least one second grid line (222), wherein the second grid line (222) is disposed on the first electrode (212) of the second subcell (21b); and the second grid line (222) comprises a second bus (2221) and a plurality of second branch lines (2222) connected to the second bus (2221), and the second branch lines (2222) are arranged on one side of the second bus (2221) at intervals.

3. The solar cell (2) according to claim 2, **characterized in that** the number of the first branch lines (2212) in the first grid lines (221) is greater than the number of the second branch lines (2222) in the second grid line (222); and
a distance between any two adjacent first branch lines (2212) in the first grid lines (221) is less than a distance between any two adjacent second branch lines (2222) in the second grid line (222).

4. The solar cell according to claim 3, **characterized in that** an area of an orthographic projection of each of the first branch lines (2212) on the corresponding first subcell (21a) is equal to an area of an orthographic projection of each of the second branch lines (2222) on the corresponding second subcell (21b).

5. The solar cell (2) according to claim 2, **characterized in that** an area of an orthographic projection of each of the first branch lines (2212) on the corresponding first subcell (21a) is greater than an area of an orthographic projection of each of the second branch lines (2222) on the corresponding second subcell (21b).

6. The solar cell (2) according to claim 4 or 5, **characterized in that** in the thickness direction of the solar cell (2), a thickness of each of the first branch lines (2212) is equal to a thickness of each of the second branch lines (2222).

7. The solar cell (2) according to any one of claims 2 to 5, **characterized in that** thicknesses of the first branch lines (2212) and thicknesses of the second branch lines (2222) are greater than or equal to 20 nm and less than or equal to 200 nm; and widths of the first branch lines (2212) and widths of the second branch lines (2222) are greater than or equal to 20 µm and less than or equal to 100 µm.

8. The solar cell (2) according to any one of claims 1 to 5, **characterized in that** the plurality of subcells (21) further comprise two third subcells (21c), the two third subcells (21c) are located between the two first subcells (21a), and each second subcell (21b) is located between the two third subcells (21c); and
an area of orthographic projections of the grid lines (22) corresponding to the third subcells (21c) on the third subcells (21c) is greater than the area of the orthographic projection of the grid line (22) corresponding to the second subcell (21b) on the second subcell (21b) and less than the area of the orthographic projections of the grid lines (22) corresponding to the first subcells (21a) on the first subcells (21a).

9. The solar cell (2) according to any one of claims 1 to 5, **characterized in that** each of the subcells (21) further comprises a second electrode (213), a first charge transport layer (214), a light absorption layer (215) and a second charge transport layer (216) that are stacked on the corresponding substrate (211), the first electrode (212) is disposed on a side of the second charge transport layer (216) facing away from the substrate (211), and the corresponding grid line (22) is disposed on a side of the first electrode (212) facing away from the substrate (211).

10. The solar cell (2) according to claim 9, **characterized in that** the light absorption layers (215) comprise perovskite layers.

11. The solar cell (2) according to claim 9, **characterized in that** extension lines (224) are disposed in the subcells (21); and
one end of each of the extension lines (224) is connected to the grid line (22) on the corresponding subcell (21), and the other end of each of the extension lines (224) is connected to the second electrode (213) of the adjacent subcell (21).

12. A preparation method for a solar cell (2), comprising:
forming a first electrode (212) on a substrate (211); and
forming a plurality of grid lines (22) on the first electrode (212), and forming a plurality of subcells (21), wherein the plurality of subcells (21) are sequentially arranged in series in a first direction; the plurality of subcells (21) comprise two first subcells (21a) and at least one second subcell (21b), and the at least one second subcell (21b) is located between the two first subcells (21a); the grid lines (22) correspond to the subcells (21) one to one, and an area of orthographic projections of the grid lines (22) corresponding to the first subcells (21a) on the first subcells (21a) is greater than an area of an orthographic projection of the grid line (22) corresponding to the second subcell (21b) on the second subcell (21b); and the first direction is perpendicular to a thickness direction of the solar cell (2).

## Patentansprüche

1. Solarzelle (2), umfassend:
eine Vielzahl von Unterzellen (21), die in einer ersten Richtung nacheinander in Reihe angeordnet sind, wobei jede der Unterzellen (21) ein Substrat (211) und eine erste Elektrode (212) umfasst, die übereinander angeordnet sind; die Vielzahl von Unterzellen (21) zwei erste Unterzellen (21a) und mindestens eine zweite Unterzelle (21b) umfasst, wobei sich die mindestens eine zweite Unterzelle (21b) zwischen den beiden ersten Unterzellen (21a) befindet; und die erste Richtung senkrecht zu einer Dickenrichtung der Solarzelle (2) verläuft; und
eine Vielzahl von Gitterleitungen (22), die auf den ersten Elektroden (212) der Unterzellen (21) in einer Eins-zu-Eins-Entsprechung angeordnet sind, **dadurch gekennzeichnet, dass** die Fläche der orthogonalen Projektionen der Gitterleitungen (22), die den ersten Unterzellen (21a) entsprechen, auf den ersten Unterzellen (21a) größer ist als die Fläche der orthogonalen Projektion der Gitterleitung (22), die der zweiten Unterzelle (21b) entspricht, auf der zweiten Unterzelle (21b).

2. Solarzelle (2) nach Anspruch 1, **dadurch gekennzeichnet, dass** die Vielzahl von Gitterleitungen (22) Folgendes umfasst:
zwei erste Gitterleitungen (221), wobei die ersten Gitterleitungen (221) auf den ersten Elektroden (212) der ersten Unterzellen (21a) angeordnet sind; und jede der ersten Gitterleitungen (221) einen ersten Bus (2211) und eine Vielzahl von ersten Abzweigleitungen (2212) umfasst, die mit dem ersten Bus (2211) verbunden sind, wobei die ersten Abzweigleitungen (2212) in Abständen auf einer Seite des ersten Busses (2211) angeordnet sind; und
mindestens eine zweite Gitterleitung (222), wobei die zweite Gitterleitung (222) auf der ersten Elektrode (212) der zweiten Unterzelle (21b) angeordnet ist; und die zweite Gitterleitung (222) einen zweiten Bus (2221) und eine Vielzahl von zweiten Abzweigleitungen (2222) umfasst, die mit dem zweiten Bus (2221) verbunden sind, und die zweiten Abzweigleitungen (2222) in Abständen auf einer Seite des zweiten Busses (2221) angeordnet sind.

3. Solarzelle (2) nach Anspruch 2, **dadurch gekennzeichnet, dass** die Anzahl der ersten Zweigleitungen (2212) in den ersten Gitterleitungen (221) größer ist als die Anzahl der zweiten Abzweigleitungen (2222) in der zweiten Gitterleitung (222); und
einen Abstand zwischen zwei beliebigen benachbarten ersten Abzweigleitungen (2212) in den ersten Gitterleitungen (221) kleiner ist als ein Abstand zwischen zwei beliebigen benachbarten zweiten Abzweigleitungen (2222) in der zweiten Gitterleitung (222).

4. Solarzelle nach Anspruch 3, **dadurch gekennzeichnet, dass** eine Fläche einer orthographischen Projektion jeder der ersten Abzweigleitungen (2212) auf die entsprechende erste Unterzelle (21a) gleich einer Fläche einer orthographischen Projektion jeder der zweiten Abzweigleitungen (2222) auf die entsprechende zweite Unterzelle (21b) ist.

5. Solarzelle (2) nach Anspruch 2, **dadurch gekennzeichnet, dass** eine Fläche einer orthographischen Projektion jeder der ersten Abzweigleitungen (2212) auf die entsprechende erste Unterzelle (21a) größer ist als eine Fläche einer orthographischen Projektion jeder der zweiten Abzweigleitungen (2222) auf die entsprechende zweite Unterzelle (21b).

6. Solarzelle (2) nach Anspruch 4 oder 5, **dadurch gekennzeichnet, dass** in der Dickenrichtung der Solarzelle (2) eine Dicke jeder der ersten Abzweigleitungen (2212) gleich einer Dicke jeder der zweiten Abzweigleitungen (2222) ist.

7. Solarzelle (2) nach einem der Ansprüche 2 bis 5, **dadurch gekennzeichnet, dass** die Dicken der ersten Abzweigleitungen (2212) und der zweiten Abzweigleitungen (2222) größer als oder gleich 20 nm und kleiner als oder gleich 200 nm sind; und
die Breiten der ersten Abzweigleitungen (2212) und der zweiten Abzweigleitungen (2222) größer als oder gleich 20 µm und kleiner als oder gleich 100 µm sind.

8. Solarzelle (2) nach einem der Ansprüche 1 bis 5, **dadurch gekennzeichnet, dass** die Vielzahl der Unterzellen (21) ferner zwei dritte Unterzellen (21c) umfasst, wobei die beiden dritten Unterzellen (21c) zwischen den beiden ersten Unterzellen (21a) angeordnet sind und jede zweite Unterzelle (21b) zwischen den beiden dritten Unterzellen (21c) angeordnet ist; und
eine Fläche der orthogonalen Projektionen der Gitterleitungen (22), die den dritten Unterzellen (21c) entsprechen, auf den dritten Unterzellen (21c) größer ist als die Fläche der orthogonalen Projektion der Gitterleitung (22), die der zweiten Unterzelle (21b) entspricht, auf der zweiten Unterzelle (21b) und unterhalb der Fläche der orthogonalen Projektionen der Gitterleitungen (22), die den ersten Unterzellen (21a) entsprechen, auf den ersten Unterzellen (21a).

9. Solarzelle (2) nach einem der Ansprüche 1 bis 5, **dadurch gekennzeichnet, dass** jede der Teilzellen (21) ferner eine zweite Elektrode (213), eine erste Ladungstransportschicht (214), eine Lichtabsorptionsschicht (215) und eine zweite Ladungstransportschicht (216) umfasst, die auf dem entsprechenden Substrat (211) übereinandergeschichtet sind, die erste Elektrode (212) auf einer dem Substrat (211) abgewandten Seite der zweiten Ladungstransportschicht (216) angeordnet ist und die entsprechende Gitterleitung (22) auf einer dem Substrat (211) abgewandten Seite der ersten Elektrode (212) angeordnet ist.

10. Solarzelle (2) nach Anspruch 9, **dadurch gekennzeichnet, dass** die Lichtabsorptionsschichten (215) Perowskit-Schichten umfassen.

11. Solarzelle (2) nach Anspruch 9, **dadurch gekennzeichnet, dass** in den Unterzellen (21) Verlängerungsleitungen (224) angeordnet sind; und
ein Ende jeder der Verlängerungsleitungen (224) mit der Gitterleitung (22) auf der entsprechenden Unterzelle (21) verbunden ist und das andere Ende jeder der Verlängerungsleitungen (224) mit der zweiten Elektrode (213) der benachbarten Unterzelle (21) verbunden ist.

12. Herstellungsverfahren für eine Solarzelle (2), umfassend:
Ausbilden einer ersten Elektrode (212) auf einem Substrat (211); und
Ausbilden einer Vielzahl von Gitterleitungen (22) auf der ersten Elektrode (212) und Bilden einer Vielzahl von Unterzellen (21), wobei die Vielzahl von Unterzellen (21) in einer ersten Richtung nacheinander in Reihe angeordnet ist; die Vielzahl von Unterzellen (21) zwei erste Unterzellen (21a) und mindestens eine zweite Unterzelle (21b) umfasst, und die mindestens eine zweite Unterzelle (21b) zwischen den beiden ersten Unterzellen (21a) angeordnet ist; die Gitterleitungen (22) den Unterzellen (21) eins zu eins entsprechen, und eine Fläche der orthogonalen Projektionen der Gitterleitungen (22), die den ersten Unterzellen (21a) entsprechen, auf den ersten Unterzellen (21a) größer ist als eine Fläche einer orthogonalen Projektion der Gitterleitung (22), die der zweiten Unterzelle (21b) entspricht, auf der zweiten Unterzelle (21b); und die erste Richtung steht senkrecht zur Dickenrichtung der Solarzelle (2).

## Revendications

1. Cellule solaire (2) comprenant :
une pluralité de sous-cellules (21), disposées séquentiellement en série dans une première direction, chacune des sous-cellules (21) comprenant un substrat (211) et une première électrode (212) qui sont empilés ; la pluralité de sous-cellules (21) comprenant deux premières sous-cellules (21a) et au moins une deuxième sous-cellule (21b), et l'au moins une deuxième sous-cellule (21b) étant située entre les deux premières sous-cellules (21a) ; et la première direction étant perpendiculaire à une direction d'épaisseur de la cellule solaire (2) ; et
une pluralité de lignes de grille (22), disposées sur les premières électrodes (212) des sous-cellules (21) selon un mode de correspondance biunivoque, **caractérisée en ce qu'**une zone de projections orthographiques des lignes de grille (22) correspondant aux premières sous-cellules (21a) sur les premières sous-cellules (21a) est supérieure à une zone de projection orthographique de la ligne de grille (22) correspondant à la deuxième sous-cellule (21b) sur la deuxième sous-cellule (21b).

2. Cellule solaire (2) selon la revendication 1, **caractérisée en ce que** la pluralité de lignes de grille (22) comprend :
deux premières lignes de grille (221), les premières lignes de grille (221) étant disposées sur les premières électrodes (212) des premières sous-cellules (21a) ; et chacune des premières lignes de grille (221) comprenant un premier bus (2211) et une pluralité de premières lignes de dérivation (2212) connectées au premier bus (2211), et les premières lignes de dérivation (2212) étant disposées d'un côté du premier bus (2211) à intervalles réguliers ; et
au moins une seconde ligne de grille (222), la seconde ligne de grille (222) étant disposée sur la première électrode (212) de la deuxième sous-cellule (21b) ; et la seconde ligne de grille (222) comprenant un second bus (2221) et une pluralité de secondes lignes de dérivation (2222) connectées au second bus (2221), et les secondes lignes de dérivation (2222) étant disposées d'un côté du second bus (2221) à intervalles réguliers.

3. Cellule solaire (2) selon la revendication 2, **caractérisée en ce que** le nombre de premières lignes de dérivation (2212) dans les premières lignes de grille (221) est supérieur au nombre de secondes lignes de dérivation (2222) dans la seconde ligne de grille (222) ; et
une distance entre l'une quelconque des deux premières lignes de dérivation (2212) adjacentes dans les premières lignes de grille (221) est inférieure à une distance entre l'une quelconque des deux secondes lignes de dérivation (2222) adjacentes dans la seconde ligne de grille (222).

4. Cellule solaire selon la revendication 3, **caractérisée en ce que** la surface d'une projection orthographique de chacune des premières lignes de dérivation (2212) sur la première sous-cellule (21a) correspondante est égale à la surface d'une projection orthographique de chacune des secondes lignes de dérivation (2222) sur la deuxième sous-cellule (21b) correspondante.

5. Cellule solaire (2) selon la revendication 2, **caractérisée en ce que** la surface d'une projection orthographique de chacune des premières lignes de dérivation (2212) sur la première sous-cellule (21a) correspondante est supérieure à la surface d'une projection orthographique de chacune des secondes lignes de dérivation (2222) sur la deuxième sous-cellule (21b) correspondante.

6. Cellule solaire (2) selon la revendication 4 ou 5, **caractérisée en ce que** dans la direction d'épaisseur de la cellule solaire (2), une épaisseur de chacune des premières lignes de dérivation (2212) est égale à une épaisseur de chacune des secondes lignes de dérivation (2222).

7. Cellule solaire (2) selon l'une quelconque des revendications 2 à 5, **caractérisée en ce que** les épaisseurs des premières lignes de dérivation (2212) et les épaisseurs des secondes lignes de dérivation (2222) sont supérieures ou égales à 20 nm et inférieures ou égales à 200 nm ; et
les largeurs des premières lignes de dérivation (2212) et des secondes lignes de dérivation (2222) sont supérieures ou égales à 20 µm et inférieures ou égales à 100 µm.

8. Cellule solaire (2) selon l'une quelconque des revendications 1 à 5, **caractérisée en ce que** la pluralité de sous-cellules (21) comprend en outre deux troisièmes sous-cellules (21c), les deux troisièmes sous-cellules (21c) sont situées entre les deux premières sous-cellules (21a), et chaque deuxième sous-cellule (21b) est située entre les deux troisièmes sous-cellules (21c) ; et
une zone des projections orthographiques des lignes de grille (22) correspondant aux troisièmes sous-cellules (21c) sur les troisièmes sous-cellules (21c) est supérieure à la zone de la projection orthographique de la ligne de grille (22) correspondant à la deuxième sous-cellule (21b) sur la deuxième sous-cellule (21b) et inférieure à la zone des projections orthographiques des lignes de grille (22) correspondant aux premières sous-cellules (21a) sur les premières sous-cellules (21a).

9. Cellule solaire (2) selon l'une quelconque des revendications 1 à 5, **caractérisée en ce que** chacune des sous-cellules (21) comprend en outre une seconde électrode (213), une première couche de transport de charge (214), une couche d'absorption de lumière (215) et une seconde couche de transport de charge (216) qui sont empilées sur le substrat correspondant (211), la première électrode (212) est disposée sur un côté de la seconde couche de transport de charge (216) opposée au substrat (211), et la ligne de grille (22) correspondante est disposée sur un côté de la première électrode (212) opposée au substrat (211).

10. Cellule solaire (2) selon la revendication 9, **caractérisée en ce que** les couches d'absorption de lumière (215) comprennent des couches de pérovskite.

11. Cellule solaire (2) selon la revendication 9, **caractérisée en ce que** des lignes d'extension (224) sont disposées dans les sous-cellules (21) ; et
une extrémité de chacune des lignes d'extension (224) est reliée à la ligne de grille (22) sur la sous-cellule correspondante (21), et l'autre extrémité de chacune des lignes d'extension (224) est reliée à la seconde électrode (213) de la sous-cellule adjacente (21).

12. Procédé de préparation d'une cellule solaire (2), comprenant :
la formation d'une première électrode (212) sur un substrat (211) ; et
la formation d'une pluralité de lignes de grille (22) sur la première électrode (212), et la formation d'une pluralité de sous-cellules (21), la pluralité de sous-cellules (21) étant disposées séquentiellement en série dans une première direction ; la pluralité de sous-cellules (21) comprenant deux premières sous-cellules (21a) et au moins une deuxième sous-cellule (21b), et au moins une deuxième sous-cellule (21b) étant située entre les deux premières sous-cellules (21a) ; les lignes de grille (22) correspondant aux sous-cellules (21) une à une, et une zone de projections orthographiques des lignes de grille (22) correspondant aux premières sous-cellules (21a) sur les premières sous-cellules (21a) étant supérieure à une zone d'une projection orthographique de la ligne de grille (22) correspondant à la deuxième sous-cellule (21b) sur la deuxième sous-cellule (21b) ; et la première direction étant perpendiculaire à une direction d'épaisseur de la cellule solaire (2).
